# EUROPÄISCHE PATENTSCHRIFT

(11) **EP 2 523 326 B1**
(45) Veröffentlichungstag und Bekanntmachung des Hinweises auf die Patenterteilung: **16.09.2015**
(21) Anmeldenummer: 11006379.9
(22) Anmeldetag: 03.08.2011
(51) Int. Cl.: H02M 1/44, H02M 3/156, H02M 3/335, H03K 17/16, G05F 3/26, H03K 17/082, H03K 17/28

(54) **Steuereinrichtung und Verfahren zum Ansteuern eines Halbleiterschalters**
Control device and method for controlling a semi-conductor switch
Dispositif de commande et procédé de commande d'un commutateur de semi-conducteur

(30) Priorität: 07.05.2011 DE 102011100760
(43) Veröffentlichungstag der Anmeldung: 14.11.2012
(73) Patentinhaber: Marks, Walter, 74653 Künzelsau (DE)
(72) Erfinder: Marks, Walter, 74653 Künzelsau (DE)
(74) Vertreter: Patentanwälte Magenbauer & Kollegen Partnerschaft mbB

(56) Entgegenhaltungen:
- EP-A1- 0 101 623
- EP-A1- 0 756 782

## Beschreibung

Die Erfindung betrifft eine Steuereinrichtung zur Beeinflussung eines Energieflusses zwischen einer elektrischen Spannungsquelle und einem elektrischen Verbraucher eines Laststromkreises, mit einem Halbleiterschalter, der eine zwischen einem Eingangsanschluss und einem Ausgangsanschluss ausgebildete, in den Laststromkreis einschleifbare Leitstrecke umfasst, deren elektrischer Widerstand mittels eines elektrischen Potentials einstellbar ist, das an einem dem Halbleiterschalter zugehörigen Steueranschluss anlegbar ist, und mit einer Steuerschaltung, die mit dem Steueranschluss gekoppelt ist und die ein parallel zum Verbraucher geschaltetes Freilaufmittel, insbesondere eine Freilaufdiode, umfasst, wobei die Steuerschaltung einen Spannungs-Stromwandler und eine mit dem Spannungs-Stromwandler elektrische verbundene Kopplungseinrichtung umfasst, wobei die Kopplungseinrichtung dazu eingerichtet ist, einen durch den Spannungs-Stromwandler fließenden elektrischen Strom in proportionaler Weise als Steuerstrom am Steueranschluss des Halbleiterschalters bereitzustellen, wobei die Steuerschaltung eine erste Kopplungseinrichtung und eine zweite Kopplungseinrichtung umfasst, die jeweils mit dem Steueranschluss des Halbleiterschalters verbunden sind und die mittels einer Umschalteinrichtung wahlweise in Reihe mit dem Spannungs-Stromwandler schaltbar sind oder wobei die Steuerschaltung einen ersten Steuerstrompfad mit einer Reihenschaltung aus einem ersten Spannungs-Stromwandler und einer ersten Kopplungseinrichtung und einen zweiten Steuerstrompfad mit einer Reihenschaltung aus einem zweiten Spannungs-Stromwandler und einer zweiten Kopplungseinrichtung sowie eine Umschalteinrichtung umfasst, die in einer ersten Funktionsstellung zur Bereitstellung eines Steuerstroms über den ersten Steuerstrompfad und in einer zweiten Funktionsstellung zur Bereitstellung eines Steuerstroms über den zweiten Steuerstrompfad an den Steueranschluss des Halbleiterschalters ausgebildet ist. Ferner betrifft die Erfindung ein Verfahren zum Steuern einer derartigen Steuereinrichtung.

In einem schaltbaren elektrischen Lastkreis liegt üblicherweise eine direkte oder eine magnetisch gekoppelte Reihenschaltung einer Spannungsquelle, eines Halbleiterschalters und eines Verbrauchers vor. Zur Vermeidung einer Überlastung des Halbleiterschalters wird dem induktivitätsbehafteten Verbraucher, dessen Induktivität ausschließlich oder anteilig durch die elektrischen Leitungen des Lastkreises bestimmt sein kann, eine Freilaufdiode parallel geschaltet.

Ein beispielsweise als MOSFET oder IGBT ausgebildeter Halbleiterschalter wird mit Hilfe einer GATE-SOURCE-Spannung gesteuert, die sich als Folge von Lade- und Entladeströmen, die am GATE angelegt werden und in Folge der verknüpften inneren Kapazitäten des Halbleiterschalters eine Steuerladung hervorrufen, eingestellt. Bei niederohmigem Halbleiterschalter liegt am Verbindungspunkt zwischen dem Halbleiterschalter und dem direkt oder magnetisch gekoppelten Verbraucher mit der Freilaufdiode im Wesentlichen das Versorgungspotential an. Wird nun die GATE-SOURCE-Spannung reduziert, um den Halbleiterschalter in einen Sperrzustand zu bringen, steigt der Innenwiderstand des Transistors an und die in ihm in Wärme umgewandelte Leistung immer größer. Dies hängt damit zusammen, dass der Strom auf Grund der Wirkung der Induktivität im Verbraucherstromkreis nur sehr wenig abnimmt. Es ist daher erforderlich, dass die Freilaufdiode den Stromfluss schnellstmöglich übernehmen kann, bevor im Transistor so viel Wärme entwickelt wird, dass dieser zerstört wird.

Aus der EP 0 756 782 B1 ist es bekannt, in Abhängigkeit von der Spannung am Freilauf-Halbleiterbauelement steuerbare Ausschaltstromquellen zur kontinuierlichen Verringerung des Betrags des Ausschaltstromes bis zu einem Minimalwert vorzusehen. Dabei wird der Minimalwert im Wesentlichen bei einem Spannungswert von 0 Volt der sich verringernden Spannung am Freilauf-Halbleiterbauteil erreicht.

Die DE 40 13 997 offenbart eine in Abhängigkeit von einem Schwellwert der Spannung am Freilauf-Halbleiterbauteil abhängig steuerbare Einschaltschaltstromquelle, die zum schlagartigen Umschalten des Betrags des Einschaltstroms auf einen hohen Wert vorgesehen ist, wenn der Schwellwert anzeigt, das das Freilauf-Halbleiterbauteil ausgeschaltet hat.

Die Aufgabe der vorliegenden Erfindung besteht daher darin, die Steuereinrichtung und das Verfahren zum Ansteuern eines Halbleiterschalters so weiterzubilden, dass beim Ein- und/oder Ausschalten des Stroms eine geringere Verlustleistung bei gleichzeitig schnelleren Schaltvorgängen des Halbleitschalters gewährleistet ist.

Diese Aufgabe wird gemäß einem ersten Aspekt mit den Merkmalen des Anspruchs 1 gelöst. Dabei ist die Umschalteinrichtung derart ausgebildet, dass sie in eine dritte Funktionsstellung, insbesondere in eine Neutralstellung, schaltbar ist, in der kein Steuerstrom von einem Spannungs-Stromwandler an den Steueranschluss des Halbleiterschalters bereitgestellt wird. Hierdurch wird nach dem Ende des Ein- oder Ausschaltvorgangs ein eindeutig vorgebbarer Schaltzustand für den Halbleiterschalter vorgegeben.

Hierdurch kann am Steueranschluss des Halbleiterschalters, insbesondere an einer Gate-Steuerelektrode eines Transistors eine hohe Stromstärke bereitgestellt werden, deren Änderungsgeschwindigkeit der Spannungs-Änderungsgeschwindigkeit am Freilaufmittel zumindest im Wesentlichen direkt proportional in der Zeit und im Betrag folgt. Dadurch kann gegenüber den aus dem Stand der Technik bekannten, durch Spannung steuerbaren Stromquellen zur Ansteuerung des Hableiterschalters ein schnellerer Schaltvorgang erzielt werden. Dies ist darauf zurückzuführen, dass bei den durch Spannung steuerbaren Stromquellen stets unvermeidbare Eingangskapazitäten, beispielsweise durch den hohen Eingangswiderstand und die notwendigen elektrischen Verbindungen ihrer Bauteile der Stromquellen, vorliegen. Hierdurch ist auch stets ein Zeitglied für die zu steuernde Stromquelle wirksam, so dass der gesteuerte Strom gegenüber der steuernden Spannung mit zunehmender Spannungs-Änderungsgeschwindigkeit zeitlich und betragsmäßig zunehmend nacheilt. Hierbei kann der Fall eintreten, dass die Verschiebung der Phasenlage zwischen Spannung und Strom der spannungsgesteuerten Stromquelle für Bruchteile der sich ändernden Freilaufspannung nach der Umwandlung in einen Steuerstrom für die Gateelektrode und davon ein Bruchteil der sich zwischen Gate und Source einstellenden Steuerspannung zusammen mit der Spannungsverstärkung im Halbleiterschalter einen Wert von 1 oder größer 1 erreicht, so dass eine unzulässige Ringverstärkung vorliegt, so dass ein selbsterregter Störsender entsteht, der elektromagnetisch unverträgliche Störleistung in die Umwelt aussendet. Erfindungsgemäß wird die über dem Freilaufmittel sich ändernde Freilaufspannung verzögerungsarm, vorzugsweise verzögerungsfrei, als Steuerstrom an dem Steueranschluss des Halbleiterschalters bereitgestellt, so dass die aus dem Stand der Technik bekannte Phasenverschiebung zumindest nahezu vollständig vermieden wird und somit eine Selbsterregung der Steuereinrichtung unterbunden wird. Hierdurch wird auch erreicht, dass beim Ein- und Ausschalten des Halbleiterschalters verglichen mit dem Stand der Technik jeweils ein schnellerer Schaltvorgang erzielt wird und dass trotz vergrößerter Spannungsänderungsgeschwindigkeit am Steueranschluss des Halbleiterschalters und somit über der Leitstrecke des Halbleiterschalters unerwünschte bzw. unzulässige Störspannungen und Störimpulse weitestgehend vermieden werden.

Ferner umfasst die Steuerschaltung einen Spannungs-Stromwandler und eine mit dem Spannungs-Stromwandler elektrisch verbundene Kopplungseinrichtung, wobei die Kopplungseinrichtung dazu eingerichtet ist, einen durch den Spannungs-Stromwandler fließenden elektrischen Strom in proportionaler Weise als Steuerstrom am Steueranschluss des Halbleiterschalters bereitzustellen. Die Aufgabe des Spannungs-Stromwandlers besteht darin, die Spannung über dem Freilaufmittel verzögerungsarm, vorzugsweise verzögerungsfrei, in einen Vorgabestrom umzuwandeln. Dieser Vorgabestrom wird an eine Kopplungseinrichtung bereitgestellt, die ihrerseits in proportionaler Abhängigkeit vom Vorgabestrom einen Steuerstrom an den Steueranschluss des Halbleiterschalters zur Verfügung stellt.

Durch die erste Kopplungseinrichtung kann beispielsweise ein Einschaltstrom an den Steueranschluss des Halbleiterschalters bereitgestellt werden, während durch die zweite Kopplungseinrichtung ein Ausschaltstrom an den Steueranschluss des Halbleiterschalters zur Verfügung gestellt wird. Mit Hilfe der Umschalteinrichtung wird wahlweise, insbesondere in Abhängigkeit von einem externen Steuersignal, entweder ein Einschaltvorgang oder ein Ausschaltvorgang für den Halbleiterschalter bewirkt.

Bei einer alternativen Ausgestaltung umfasst die Steuerschaltung einen ersten Steuerstrompfad mit einer Reihenschaltung aus einem ersten Spannungs-Stromwandler und einer ersten Kopplungseinrichtung und einen zweiten Steuerstrompfad mit einer Reihenschaltung aus einem zweiten Spannungs-Stromwandler und einer zweiten Kopplungseinrichtung sowie eine Umschalteinrichtung, die in einer ersten Funktionsstellung zur Bereitstellung eines Steuerstroms über den ersten Steuerstrompfad und in einer zweiten Funktionsstellung zur Bereitstellung eines Steuerstroms über den zweiten Steuerstrompfad an den Steueranschluss des Halbleiterschalters ausgebildet ist.

Vorteilhafte Weiterbildungen der Erfindung sind in den Unteransprüchen angegeben.

Bevorzugt ist die Kopplungseinrichtung als Stromspiegel oder als elektrischer Pegelschieber, insbesondere als Transistor, ausgebildet.

Bei einer Weiterbildung der Erfindung ist vorgesehen, dass der Spannungs-Stromwandler wenigstens einen Wirkwiderstand umfasst, der insbesondere ausschließlich als ohmscher Widerstand, ausgebildet ist. Dadurch kann eine verzögerungsarme, insbesondere verzögerungsfreie, Wandlung der elektrischen Spannung über dem Freilaufmittel in den Vorgabestrom erreicht werden.

Vorteilhaft ist es, wenn der Spannungs-Stromwandler als Reihenschaltung von mehreren, insbesondere elektrisch gleichwertigen, Wirkwiderständen ausgebildet ist, die zur Reduzierung von Induktionseffekten mäanderförmig angeordnet sind. Hierdurch werden Induktionseffekte in den Wirkwiderständen gegenseitig zumindest teilweise egalisiert und somit in Summe reduziert. Hierzu sind die Wirkwiderstände hinsichtlich ihrer mechanischen Ausrichtung und/oder ihrer Stromflussrichtung zumindest im Wesentlichen parallel und gegebenenfalls unittelbar benachbart zueinander angeordnet. Besonders bevorzugt sind die Wirkwiderstände elektrisch gleichwertig ausgebildet, weisen also jeweils den gleichen ohmschen Widerstand auf. Besonders bevorzugt sind die Wirkwiderstände auch hinsichtlich ihrer mechanischen Aufbauweise und ihrer mechanischen Abmessungen gleichartig, insbesondere identisch, ausgebildet.

Bei einer Weiterbildung der Erfindung ist der Umschalteinrichtung eine Ansteuereinrichtung zugeordnet, die anhand einer vorgebbaren Zeitdauer oder anhand einer Detektion einer minimalen oder maximalen elektrischen Spannung zwischen dem Eingangsanschluss und dem Ausgangsanschluss des Halbleiterschalters zur Umschaltung der Umschalteinrichtung in die dritte Funktionsstellung ausgebildet ist.

Somit wird der eindeutige Schaltzustand des Halbleiterschalters nach dem Ein- oder Ausschaltvorgang entweder nach Ablauf einer vorgebaren Zeitspanne, die mit dem Eintreffen des externen Steuersignals beginnt, oder nach entsprechender Detektion einer vorgebbaren maximalen oder minimalen elektrischen Spannung zwischen dem Eingangsanschluss und dem Ausgangsanschluss des Halbleiterschalters eingenommen.

Gemäß einem zweiten Aspekt der Erfindung ist ein Verfahren mit den Merkmalen des Anspruchs 7 vorgesehen. Bei diesem Verfahren zum Steuern einer Steuereinrichtung wird bei einer Änderung einer Spannung über dem Freilaufmittel eine Änderung eines Stromflusses in einem Spannungs-Stromwandler, der der Spannung über dem Freilaufmittel parallelgeschaltet ist, als proportionale Steuerstromänderung an einen Steueranschluss des Halbleiterschalters bereitgestellt. Dabei wird für einen Einschaltvorgang und/oder einen Ausschaltvorgang des Halbleiterschalters ein externes Steuersignal an die Umschalteinrichtung bereitgestellt, wobei eine Umschaltung der Umschalteinrichtung aus der ersten oder zweiten Funktionsstellung in die dritte Funktionsstellung nach Ablauf einer vorgebbaren Zeitdauer nach Eintreffen des Steuersignals oder bei Detektion einer vorgebbaren minimalen oder maximalen elektrischen Spannung zwischen dem Eingangsanschluss und dem Ausgangsanschluss und/oder zwischen dem Eingangsanschluss und dem Steueranschluss des Halbleiterschalters vorgenommen wird.

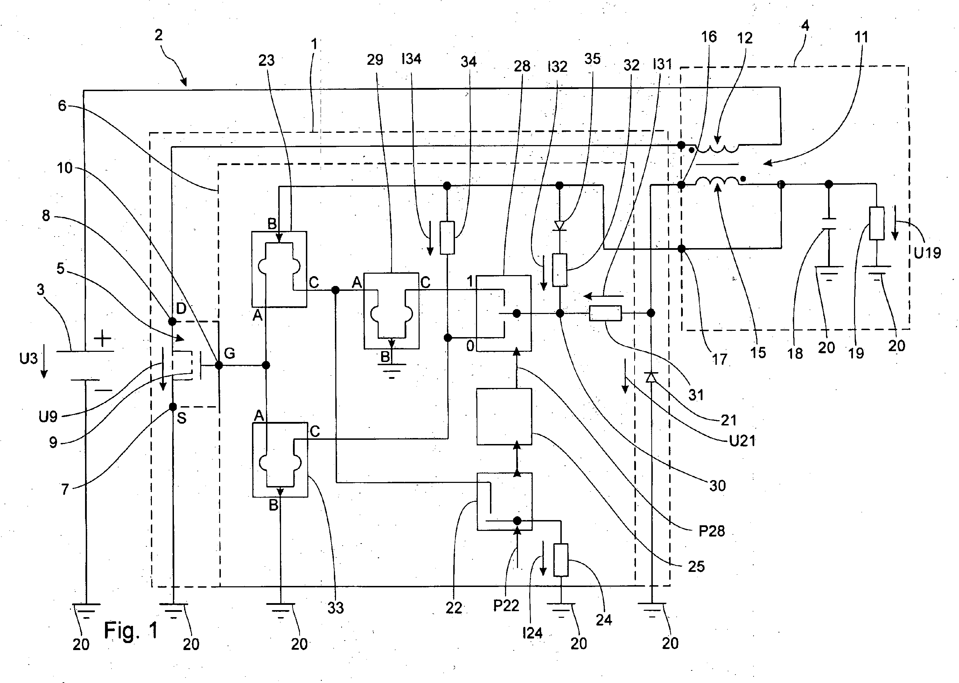

Vorteilhafte Ausführungsformen der Erfindung sind in der Zeichnung dargestellt. Dabei zeigt:
- Figur 1:: eine Darstellung eines Schaltungsaufbaus für eine Steuereinrichtung gemäß einer ersten Ausführungsform und
- Figur 2:: eine Darstellung eines Schaltungsaufbaus für eine Steuereinrichtung gemäß einer zweiten Ausführungsform.
Bei dem in Fig. 1 dargestellten Ausführungsbeispiel ist eine Beeinflussung eines elektrischen Energiestroms in einen Laststromkreis 2 durch eine Steuereinrichtung 1 vorgesehen. Der Laststromkreis 2 umfasst neben der Steuereinrichtung 1 eine exemplarisch als Gleichstromquelle ausgebildete Spannungsquelle 3 mit der Versorgungsspannung U3 und einen Verbraucher 4.

Die Steuereinrichtung 1 umfasst als wesentliche Bestandteile einen Halbleiterschalter 5 und eine Steuerschaltung 6 zur Ansteuerung des Halbleiterschalters 5. Der Halbleiterschalter 5 ist mit einem Eingangsanschluss 7, der auch als Source (S) bezeichnet wird und mit einem Ausgangsanschluss 8, der auch als Drain (D) bezeichnet wird, in den Laststromkreis 2 eingeschleift. Zur Beeinflussung eines elektrischen Widerstands einer zwischen dem Eingangsanschluss 7 und dem Ausgangsanschluss 8 im Halbleiterschalter 5 ausgebildeten Leitstrecke 9 ist ein auch als Gate (G) bezeichneter Steueranschluss 10 vorgesehen. Der Steueranschluss 10 ist mit dem Verbraucher 4 über die Steuerschaltung 6 in nachstehend näher beschriebener Weise gekoppelt.

Exemplarisch umfasst der Verbraucher 4 einen transformatorischen Übertrager 11 mit einer Primärwicklung 12 und einer Sekundärwicklung 15. Die Primärwicklung 12 ist derart in den Laststromkreis 2 eingeschleift, dass ein durch die Leitstrecke 9 fließender Strom auch durch die Primärwicklung 12 fließt. Die Sekundärwicklung 15 ist an einem ersten Endbereich mit einem ersten Kopplungsanschluss 16 und mit einem zweiten Endbereich mit einem zweiten Kopplungsanschluss 17 der Steuerschaltung 6 verbunden. Zudem sind dem zweiten Endbereich der Sekundärwicklung 15 ein Kondensator 18 und ein Widerstand 19 zugeordnet, die jeweils gegen einen Masseanschluss 20 geschaltet sind.

Elektrisch betrachtet bilden die Spannungsquelle 3, die Leitstrecke 9 und die Primärwicklung 12 einen Primär-Magnetisierungs-Stromkreis. Die Sekundärwicklung 15 bildet zusammen mit dem Kondensator 18 und dem Widerstand 19 sowie mit einem, exemplarisch als Freilaufdiode 21 ausgebildeten und dem Verbraucher 4 parallelgeschalteten, Freilaufmittel einen Sekundär-Entmagnetisierungs-Stromkreis.

Die im Übertrager 11 während der Einschaltzeit des Halbleiterschalters 5 aufgenommene Energie wird erst in der Sperrphase des Halbleiterschalters 5, in der die Leitstrecke 9 einen hohen elektrischen Widerstand aufweist, an den Kondensator 18 und den Widerstand 19 im Verbraucher 4 abgegeben.

Exemplarisch ist die Kapazität des Kondensators 18 so groß gewählt, dass die Verbraucherspannung U19 über dem Widerstand 19 während der Einschaltzeit des Halbleiterschalters 5 nur sehr wenig abnimmt und dementsprechend während der Ausschaltzeit des Halbleiterschalters 5 nur sehr wenig zunimmt.

Ein nicht näher dargestellter Regler ist dazu vorgesehen, Signale mit einer vorgebbaren Pulsweite auszugeben, um am Verbraucher 4 eine im Wesentlichen konstante Verbraucherspannung U19 zu gewährleisten.

Bei widerstandsarm geschalteter, niederohmiger Leitstrecke 9 ist der mit einem Punkt gekennzeichnete, mit dem Ausgangsanschluss 8 des Halbleiterschalters 5 verbundene Wicklungsanfang der Primärwicklung 12 mit dem Massepotential am Masseanschluss 20 verbunden. Am Wicklungsende der Primärwicklung 12 liegt zu diesem Zeitpunkt das positive Versorgungspotential +U3 an und verursacht in der Primärwicklung 12 während einer Einschaltphase einen ansteigenden Primär-Magnetisierungsstrom. Hierdurch wird im Übertrager 11 die Spannung +U3 gemäß dem Verhältnis der Windungszahlen der Primärwicklung 12 zur Sekundärwicklung 15 transformiert und ist dabei so gepolt, dass die Sperrspannung U21 an der Freilaufdiode 21 um die transformierte Spannung größer ist als die im wesentlichen konstante Spannung +U19 am Widerstand 19.

Bei hochohmig geschalteter Leitstrecke 9 des Halbleiterschalters 5 ist das mit dem Kopplungsanschluss 16 verbundene Ende der Sekundärwicklung 15 negativ gepolt und ist über die Freilaufdiode 21 mit dem Massepotential verbunden. Am Wicklungsanfang der Sekundärwicklung 15, der mit dem Kopplungsanschluss 17 verbunden ist, liegt das positive Potential +U19 an und verursacht während einer Ausschaltphase einen abnehmenden Sekundär-Entmagnetisierungsstrom. Hierbei wird im Übertrager 11 die Summe der Spannungen +U19 und +U21 gemäß dem Verhältnis der Windungszahlen von Sekundärwicklung 15 zu Primärwicklung 12 transformiert und dabei so gepolt, dass die Spannung U9 über der Leitstrecke 9 zwischen dem Eingangsanschluss 7 und dem Ausgangsanschluss 8 des Halbleiterschalters 5, die auch als Drain-Source-Spannung bezeichnet wird, um die transformierte Spannung größer ist als die im wesentlichen konstante Spannung +U3.

Um eine Änderung der Leitstrecke 9 zwischen einem niederohmigen und einem hochohmigen Zustand zu erreichen, wird zunächst vom nicht dargestellten Regler ein Ausschaltsignal P22(0) an einen Schalter 22 bereitgestellt. Der Schalter 22 unterbricht eine elektrische Verbindung zwischen einem Stromspiegel 23 und einem Wirkwiderstand 24, der mit einem Masseanschluss 20 verbunden ist. Von einem Zeitglied 25 wird nach Eintreffen des Signals P22(0) für eine vorgebbare Zeitspanne Δt ein Ausschaltsignal P28(0) an eine als Umschalter 28 ausgebildete Umschalteinrichtung ausgegeben. Dieser Umschalter 28 kann in Abhängigkeit von einer Signalfolge und/oder einem Signalpegel des Signals P28 exemplarisch zwischen drei Schaltstellungen umgeschaltet werden. Bei Eintreffen des Ausschaltsignals P28(0) wird der Umschalter 28 in eine mit 0 bezeichnete Ausschaltstellung gebracht. In der Ausschaltstellung des Umschalters 28 liegt keine Verbindung zwischen einem Stromspiegel 29 und einem Verbindungspunkt 30, der mit den Wirkwiderständen 31 und 32 verbunden ist, vor. Da sowohl die Verbindung des Stromspiegels 23 zum Wirkwiderstand 24 als auch zum Verbindungspunkt 30 unterbrochen ist, wird der Strompfad 23B-23C im Stromspiegel 23 stromlos. Dementsprechend wird auch der Strompfad 23A-23B des Stromspiegels 23 zum Steueranschluss 10 des Halbleiterschalters 5 stromlos.

Vielmehr verbindet der Umschalter 28 die Wirkwiderstände 31 und 32 mit dem Stromspiegel 33. Hierbei werden Beträge von Strömen I31 und I32, die durch die Wirkwiderstände 31 und 32 fließen, zu dem Betrag eines Stroms I34 durch den Wirkwiderstand 34 addiert und der daraus resultierende Summenstrom im Stromspiegel 33 gespiegelt. Der dadurch im Strompfad 33A-33B eingeprägte Strom verringert das am Steueranschluss 10 (Gate G) anliegende elektrische Potential und erhöht somit den Widerstand der Leitstrecke 9.

Bei dem vorstehend beschriebenen Ausschaltvorgang für den Halbleiterschalter 5 erfolgt die Änderung der Leitfähigkeit der Leitstrecke 9 und damit der Spannung U-Drain-Source zwischen dem Eingangsanschluss 7 und dem Ausgangsanschluss 8 des Halbleiterschalters 5 durch Aufladung der inhärent im Halbleiterschalter 5 vorliegenden Miller-Kapazität mit dem gesamten Spannungshub in Höhe der Summe aus der Versorgungsspannung U3 und der im Übertrager 11 transformierten Spannungen U19+U21. Die Aufladung der Miller-Kapazität im Halbleiterschalter 5 erfolgt durch den in den Strompfad 33A-33B eingeprägten Strom.

Mit der Verringerung der Spannung U21 an der Freilaufdiode 21 verringert sich der Strom I31 durch den Widerstand 31 in proportionaler Weise. Im weiteren Verlauf des Abschaltvorgangs tritt eine Umpolung der Freilaufdiode 21 ein, die zu einem negativen Strom -I31 führt. Vorzugsweise ist der Wirkwiderstand 32 so bemessen, dass in dieser Situation der Betrag des Stroms I32 den Betrag des negativen Stroms -I31 im Wesentlichen kompensiert, so dass nur noch der Strom I34 im Wirkwiderstand 34 an den Stromspiegel 33 bereitgestellt und von diesem gespiegelt wird. Der gespiegelte Strom verringert die Steuerladung (U-Gate-Source) am Steueranschluss 10 des Halbleiterschalters 5.

Zum Wiedereinschalten des Halbleiterschalters 5 wird das Signal P22(1) an den Umschalter 22 bereitgestellt. Dadurch wird eine elektrische Verbindung zwischen dem Wirkwiderstand 24 und dem Stromspiegel 23 hergestellt, wodurch eine Verbraucherspannung U19 zu einem Stromfluss im Strompfad B23-C23 im Stromspiegel 23 führt. Ein Betrag dieses Stroms ergibt sich zu I24 = U19/R24, wobei R24 der ohmsche Widerstand des Wirkwiderstands 24 ist.

Zudem wird ein Einschaltsignal P28(1) an den Umschalter 28 ausgegeben, der dadurch in die mit 1 bezeichnete Schaltposition wechselt und eine elektrisch leitende Verbindung zwischen dem Verbindungspunkt 30 und dem Stromspiegel 29 herstellt. Hierdurch wird ein Summenstrom aus den Strömen I31 und I32, der vor der Umpolung der Freilaufspannung in die Sperrrichtung im Wesentlichen den Betrag Null aufweist, und des Stroms I24 mit Hilfe des Stromspiegels 23 als Ladestrom an den Steueranschluss 10 des Halbleiterschalters 5 bereitgestellt. Dadurch wird die Spannung zwischen dem Steueranschluss 10 und dem Eingangsanschluss 7 (U-Gate-Source) vergrößert und eine Reduzierung des ohmschen Widerstands der Leitstrecke 9 herbeigeführt. Hierdurch tritt in der Primärwicklung 12 des Übertragers 11 ein zunehmender Magnetisierungsstrom auf, der zu einem abnehmenden Entmagnetisierungsstrom in der Sekundärwicklung 15 führt. Dadurch wird der Freilaufstrom I21 durch die Freilaufdiode 21 verringert und führt innerhalb der Umschaltzeit für das Ausschalten des Freilaufstroms dazu, dass sich die Freilaufspannung U21 umpolt und positiv wird. Der im wesentlichen konstante Strom I32 wird dabei aufgrund der Verringerung der zunächst negativen Freilaufspannung U21 an der Freilaufdiode 21 auf einen Betrag oberhalb deren negativen Flussspannung mit einem zunehmendem Anteil in den Strompfad 29C-29B des Stromspiegels 29 und mit einem proportional abnehmendem Anteil durch den Wirkwiderstand 31 gelenkt. Der Summenstrom aus I31 und I32 steigt proportional zur positiver werdenden Freilaufspannung U21 an und vergrößert über die Stromspiegelungen in den Stromspiegeln 29 und 23 die Steuerladung am Steueranschluss 10 (U-Gate-Source) des Halbleiterschalters 5.

Die vom Zeitglied 25 vorgebbare Zeitspanne Δt entspricht im Wesentlichen der Schaltzeit des Halbleiterschalters 5. Dementsprechend wird nach Ablauf der Zeitspanne Δt der Umschalter 28 in den dritten Zustand geschaltet, so dass der Summenstrom aus I31 und I32 zum Stromspiegel 29 unterbrochen wird. Damit wird der Steuerstrom am Steueranschluss 10 nur noch vom Strom I24 über den Wirkwiderstand 24, der vom Stromspiegel 23 gespiegelt wird, bestimmt. Ein Stromfluss von der höheren positiven Spannung U21 der Freilaufdiode 21 über die Wirkwiderstände 31 und 32 zur Verbraucherspannung U19 durch eine diesbezüglich in Sperrrichtung gepolte, dem Wirkwiderstand 32 vorgeschaltete Diode 35 verhindert.

Bei der dargestellten Steuerschaltung 6 ist gewährleistet, dass sich die Spannung zwischen dem Eingangsanschluss 7 und dem Ausgangsanschluss 8 des Halbleiterschalters 5 stetig-harmonisch und frei von elektromagnetischer Oszillation ändert. Dies hängt damit zusammen, dass die Steuerladung am Steueranschluss 10 durch einen sich stetig-harmonisch proportional ändernden und von elektromagnetischer Oszillation freien Stroms bestimmt wird. Dabei ist der zeitliche Verlauf der Umladung der internen Miller-Kapazität im Halbleiterschalter zwischen dem Steueranschluss 10 (Gate) und dem Ausgangsanschluss 8 (Drain) des Halbleiterschalters 5 und damit die zeitliche Änderung der Spannung zwischen dem Ausgangsanschluss 8 (Drain) und Eingangsanschluss 7 (Source) so gewählt, dass während eines Ein- oder Ausschaltvorgangs für den Halbleiterschalter 5 die Spannung zwischen dem Steueranschluss 10 (Gate) und dem Eingangsanschluss 7 (Source) des Halbleiterschalters 5 im wesentlichen konstant bleibt. Außerdem wird durch die gewählte Gestaltung der Steuerschaltung 6 gewährleistet, dass die sich ändernde Spannung zwischen dem Ausgangsanschluss 8 (Drain) und den Eingangsanschluss 7 (Source) im Verhältnis der Windungszahlen zwischen der Primärwicklung 12 und der Sekundärwicklung 15 des Übertragers 11 an die Freilaufdiode 21 übertragen wird und dort die Spannung U21 stetig-harmonisch und frei von elektromagnetischer Oszillation bis zur Flussspannung -U21 ändert.

Zudem ist die sich so ändernde Spannung U21 über dem reinen Wirkwiderstand 31 wirksam, so dass sich ohne Zeitverzug der proportional folgende Strom I31 einstellt und ohne Phasendrehung über den Stromspiegel 33 an den Steueranschluss 10 des Halbleiterschalters 5 eingespiegelt wird.

Hierdurch wird eine 180-Grad-Stromgegenkopplung zwischen dem Ausgangsanschluss 8 (Drain) und dem Steueranschluss 10 (Gate) des Halbleiterschalters aus sehr hohen Spannungsänderungsgeschwindigkeiten für die Spannung zwischen Eingangs- und Ausgangsanschluss 7,8 und für die Spannung U21 an der Freilaufdiode vom Wirkwiderstand 31 phasengenau umgeformt. Dadurch ist beim Einschaltvorgang für den Halbleiterschalter 5 gewährleistet, dass die Spannung zwischen dem Eingangsanschluss 7 und dem Ausgangsanschluss 8 frei von elektromagnetischer Oszillation absteigt, da die Spannung zwischen dem Steueranschluss 10 und dem Eingangsanschluss 7 durch einen proportional zur absteigenden Spannung zwischen Eingangsanschluss 7 und Ausgangsanschluss 8 ansteigenden Strom vergrößert wird, der den zeitlichen Verlauf der Entladung der internen Miller-Kapazität des Halbleiterschalters 5 und damit den Abstieg der Spannung zwischen dem Eingangsanschluss 7 und dem Ausgangsanschluss 8 so festlegt, dass während des Abstiegs der Spannung zwischen dem Eingangsanschluss 7 und dem Ausgangsanschluss 8 die Spannung zwischen dem Steueranschluss 10 und dem Eingangsanschluss 7 im wesentlichen konstant bleibt.

Hierdurch wird die sich so ändernde Spannung zwischen dem Eingangsanschluss 7 und dem Ausgangsanschluss 8 im Verhältnis der Windungszahlen zwischen der Primärwicklung 12 und der Sekundärwicklung 15 des Übertragers 11 an die Freilaufdiode 21 übertragen, dort wird die Spannung U21 oberhalb der Flussspannung -U21 in positiver Richtung geändert und die sich so ändernde Spannung U21 wird vom Wirkwiderstand 31 in einen in Betrag und Zeit proportionalen Strom I31, der über den Umschalter 28 und die Stromspeigel 29 und 23an den Steueranschluss 10 um 180 Grad gegenphasig zur verursachenden Spannung zwischen dem Eingangsanschluss 7 und dem Ausgangsanschluss 8 eingespeist wird und die Gegenphasigkeit elektromagnetischer Oszillation unterdrückt.

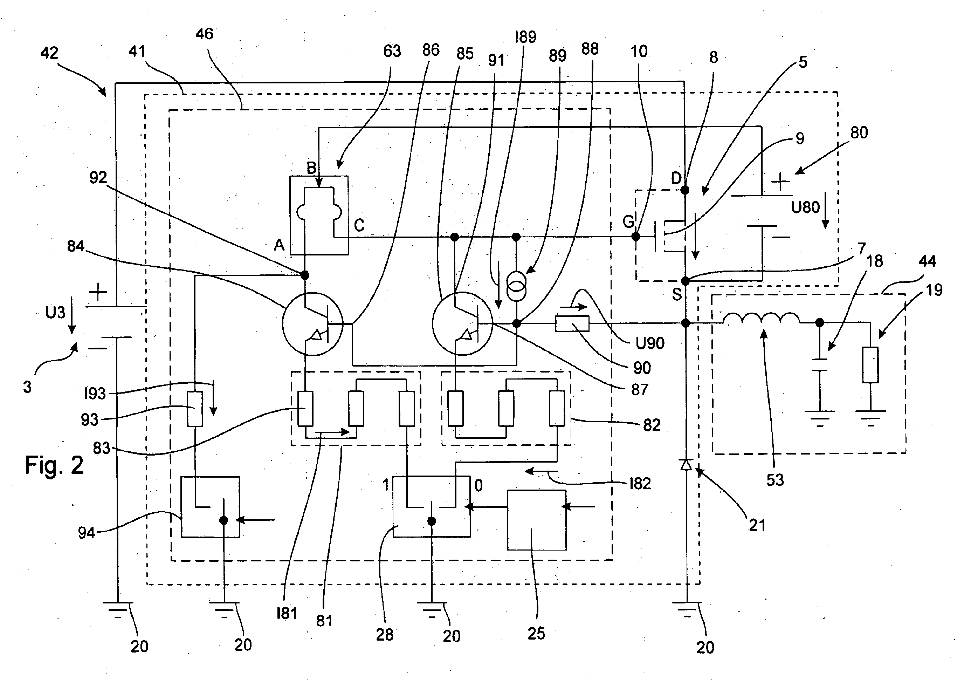

Die in der Figur 2 dargestellte zweite Ausführungsform einer Steuereinrichtung 41 weist im Wesentlichen die gleiche Funktionalität wie die Steuereinrichtung 1 auf, so dass Komponenten mit zumindest im Wesentlichen identischer Funktion mit den gleichen Bezugszeichen versehen sind.

Exemplarisch weist der Verbraucher 44 keinen Übertrager auf, wie er bei der ersten Ausführungsform gemäß der Figur 1 dargestellt ist, sondern umfasst eine Parallelschaltung eines Kondensators 18 und eines Widerstands 19, die in Reihe mit einer Induktivität 53 geschaltet sind. Beide Verbraucher 4, 44 sollen jeweils beliebige Kombinationen von elektrischen und/oder elektronischen Komponenten mit ohmschen, induktiven und kapazitiven Anteilen darstellen.

Parallel zum Verbraucher 44 ist auch bei der zweiten Ausführungsform der Steuereinrichtung 41 das als Freilaufdiode 21 ausgebildete Freilaufmittel geschaltet. Alternativ kann das Freilaufmittel bei beiden Ausführungsformen der Steuerschaltung 6, 46 als MOSFET, IGBT oder als SICFET ausgebildet sein.

Zusätzlich zu der Spannungsquelle 3 ist bei der Steuereinrichtung 41 eine Hilfsspannungsquelle 80 vorgesehen, deren Versorgungspotential U80 zur Stromversorgung des Stromspiegels 63 dient. Handelt es sich bei dem Halbleiterschalter 5 exemplarisch um einen N-Kanal-MOSFET, der als Source-Folger geschaltet ist, so muss die Spannung am Steueranschluss 10 zum Einschalten, also zur Verringerung des ohmschen Widerstands der Leitstrecke 9, positiver werden als die Versorgungsspannung am Ausgangsanschluss 8. Hierzu dient die Hilfsspannungsquelle, die dem Stromspiegel ein elektrisches Potential bereitstellt, das sich durch Addition des Versorgungspotentials U3 und des Versorgungspotentials U80 ergibt.

An einem ersten mit der Ziffer 1 bezeichneten Ausgangsanschluss des Umschalters 28 ist eine erste Wirkwiderstandsanordnung 81 angeschlossen, die exemplarisch aus mehreren in Reihe geschalteten, vorzugsweise elektrisch gleichwertigen, ohmschen Widerständen 83 gebildet ist. An einem zweiten mit der Ziffer 0 bezeichneten Ausgangsanschluss des Umschalters 28 ist eine zweite Wirkwiderstandsanordnung 82 angeschlossen, die ebenfalls exemplarisch aus mehreren in Reihe geschalteten, vorzugsweise elektrisch gleichwertigen, ohmschen Widerständen 83 gebildet ist. Bei beiden Wirkwiderstandsanordnungen sind die ohmschen Widerstände 83 mäanderförmig angeordnet, insbesondere unmittelbar benachbart angeordnet und in jeweils entgegengesetzter Richtung stromdurchflossen, so dass Induktivitätseffekte minimiert werden können.

Jede der Wirkwiderstandsanordnungen 81, 82 ist jeweils mit einem exemplarisch als NPN-Transistor 84, 85 ausgebildeten Pegelschieber oder Levelshifter verbunden. Der mit der ersten Wirkwiderstandsanordnung 81 verbundene NPN-Transistor 84 ist mit seiner als Steueranschluss 86 bezeichneten Basis an einen Verbindungspunkt 88 angeschlossen, mit dem auch der Steueranschluss 87 bzw. die Basis des zweiten NPN-Transistors 85 sowie eine Ausschaltstromquelle 89 und ein Widerstand 90 verbunden sind.

Der Widerstand 90 ist mit dem Eingangsanschluss 7 des Halbleiterschalters 5 verbunden. Die Ausschaltstromquelle 89 ist mit dem Steueranschluss 10 des Halbleiterschalters 5, mit dem auch als Kollektor bezeichneten Eingangsanschluss 91 des zweiten NPN-Transistors 85 und mit dem Ausgangsanschluss 63C des Stromspiegels 63 verbunden.

Der erste NPN-Transistor 84 ist mit seinem auch als Kollektor bezeichneten Eingangsanschluss 92 mit dem Anschluss 63A des Stromspiegels 63 verbunden. An diesem Anschluss 63A ist auch ein Widerstand 93 angeschlossen, der über einen Schalter 94 mit dem Massepotential 20 verbindbar ist.

Für einen Einschaltvorgang des Halbleiterschalters 5 ist vorgesehen, dass aufgrund eines von außen eingespeisten Steuersignals der Schalter 94 betätigt wird, so dass eine leitende Verbindung zwischen dem Massepotential 20 und dem Widerstand 93 besteht. Zudem wird mit dem gleichen Steuersignal der Umschalter 28 aus der in Figur 2 dargestellten dritten Funktionsstellung, bei der es sich um eine Neutralstellung handelt, in eine erste Funktionsstellung gebracht, in der eine elektrisch leitende Verbindung zwischen dem Massepotential 20 und der Wirkwiderstandsanordnung 81 hergestellt wird. Über den Widerstand 93 fließt ein Strom I93, der sich aus dem Quotienten aus der Summe der Spannung U21 über der Freilaufdiode 21 und der Hilfsspannung U80 der Hilfsspannungsquelle 80 geteilt durch den ohmschen Widerstand R93 des Widerstands 93 ergibt.

Durch die Kollektor-Emitterstrecke des NPN-Transistors 84 und durch die Wirkwiderstandsanordnung 81 fließt ein Strom I81 gemäß dem Quotienten aus der Summe der Spannung U21 über der Freilaufdiode 21 und der Spannung U90 über dem Widerstand 90 geteilt durch den ohmschen Widerstand R81 der ersten Wirkwiderstandsanordnung 81.

Am Anschluss 63A des Stromspiegels 63 fließt ein Strom, der sich als Summe aus I93 und I81 ergibt. Dieser Strom wird im Stromspiegel 63 gespiegelt. Am Anschluss 63C des Stromspiegels 63 fließt der gespiegelte Betrag dieses Stroms. Somit liegt am Steueranschluss 10 des Halbleiterschalters 5 ein Strom an, der sich aus der Differenz zwischen dem gespiegelten Strom und dem fest eingestellten Strom I89 der Ausschaltstromquelle 89 ergibt, der seinerseits solange fließt, so lang eine Potentialdifferenz zwischen dem Steueranschluss 10 und dem Eingangsanschluss 7 des Halbleiterschalters 5 vorliegt.

Mit Ablauf einer im Zeitglied 25 vorgebbar gespeicherten Zeitdauer wird der Umschalter 28 in die dritte Funktionsstellung umgeschaltet, so dass die Wirkwiderstandsanordnung 81 vom Massepotential 20 abgekoppelt wird und das Potential am Steueranschluss 10 des Halbleiterschalters 5 durch den im Stromspiegel 63 gespiegelten Stromfluss durch den Widerstand 93 aufrechterhalten wird.

Für einen Abschaltvorgang wird mit Hilfe eines externen Steuersignals der Schalter 94 in einen geöffneten zustand versetz, so dass die Verbindung zwischen dem Widerstand 93 und dem Massepotential 20 unterbrochen wird. Zudem wird der Umschalter 28 aus der dritten Funktionsstellung in eine zweite Funktionsstellung umgeschaltet, in der eine elektrische Verbindung zwischen dem Massenpotential 20 und der zweiten Wirkwiderstandsanordnung 82 hergestellt wird. Dadurch fließt durch die Kollektor-Emitterstrecke des zweiten NPN-Transistors 85 ein von der Summe aus Freilaufspannung U21 und der Spannung U90 durch den Widerstand der Wirkwiderstandsanordnung 82 bestimmter Strom I82. Dieser Strom I82 wird von der Steuerladung zwischen dem Eingangsanschluss 7 und dem Steueranschluss 10 des Halbleiterschalters 5 gespeist und fließt durch den NPN-Transistor 85, so dass die Steuerladung im Halbleiterschalter 5 reduziert wird. Dadurch steigt der ohmsche Widerstand der Leitstrecke 9 und die Spannung U21 über der Freilaufdiode 21 verringert sich und wird negativ. Dadurch wird die Freilaufdiode 21 zunehmend stromleitend.

Sobald die Spannung an der Basis des NPN-Transistors 85 gegenüber dem Masseanschluss 20 den Wert 0 Volt erreicht, fließt durch die zweite Wirkwiderstandsanordnung 82 kein Strom mehr. Somit wird die Steuerladung im Halbleiterschalter 5 allein durch die Ausschaltstromquelle 89 bestimmt, deren Strom im Betrag an die Einschaltdauer der Freilaufdiode 21 angepasst ist. Zudem ist auch der ohmsche Widerstand des Widerstands 90 derart an den Betrag des Ausschaltstroms der Ausschaltstromquelle 89 angepasst, dass die Spannung über dem Widerstand 90 im Wesentlichen der Flussspannung der Freilaufdiode 21 entspricht.

Nach Ablauf einer vorgebbaren Zeitdauer nach Eintreffen des Ausschaltsignals wird von dem Zeitglied 25 der Umschalter 28 in die dritte Funktionsstellung geschaltet, so dass die elektrische Verbindung der Wirkwiderstandsanordnung 82 mit dem Massepotential 20 unterbrochen wird.

## Patentansprüche

1. Steuereinrichtung zur Beeinflussung eines Energieflusses zwischen einer elektrischen Spannungsquelle (3) und einem elektrischen Verbraucher (4; 44) eines Laststromkreises (2; 42), mit einem Halbleiterschalter (5), der eine zwischen einem Eingangsanschluss (7) und einem Ausgangsanschluss (8) ausgebildete, in den Laststromkreis (2; 42) einschleifbare Leitstrecke (9) umfasst, deren elektrischer Widerstand mittels eines elektrischen Potentials einstellbar ist, das an einem dem Halbleiterschalter (5) zugehörigen Steueranschluss (10) anlegbar ist, und mit einer Steuerschaltung (6; 46), die mit dem Steueranschluss (10) gekoppelt ist und die ein parallel zum Verbraucher (4; 44) geschaltetes Freilaufmittel (21), insbesondere eine Freilaufdiode, umfasst, wobei die Steuerschaltung (6; 46) für eine Bereitstellung eines Steuerstroms an den Steueranschluss (10) ausgebildet ist, der einer Freilaufspannung über dem Freilaufmittel (21) proportional ist und wobei die Steuerschaltung (6; 46) einen Spannungs-Stromwandler (31; 81, 82) und eine mit dem Spannungs-Stromwandler (31; 81, 82) elektrische verbundene Kopplungseinrichtung (23, 33; 84; 85) umfasst, wobei die Kopplungseinrichtung (23, 33; 84, 85) dazu eingerichtet ist, einen durch den Spannungs-Stromwandler (31; 81, 82) fließenden elektrischen Strom in proportionaler Weise als Steuerstrom am Steueranschluss (10) des Halbleiterschalters (5) bereitzustellen, - wobei die Steuerschaltung (6) eine erste Kopplungseinrichtung (33) und eine zweite Kopplungseinrichtung (23) umfasst, die jeweils mit dem Steueranschluss (10) des Halbleiterschalters (5) verbunden sind und die mittels einer Umschalteinrichtung (28) wahlweise in Reihe mit dem Spannungs-Stromwandler (31) schaltbar sind oder
- wobei die Steuerschaltung (46) einen ersten Steuerstrompfad mit einer Reihenschaltung aus einem ersten Spannungs-Stromwandler (81) und einer ersten Kopplungseinrichtung (84) und einen zweiten Steuerstrompfad mit einer Reihenschaltung aus einem zweiten Spannungs-Stromwandler (82) und einer zweiten Kopplungseinrichtung (85) sowie eine Umschalteinrichtung (28) umfasst, die in einer ersten Funktionsstellung zur Bereitstellung eines Steuerstroms über den ersten Steuerstrompfad und in einer zweiten Funktionsstellung zur Bereitstellung eines Steuerstroms über den zweiten Steuerstrompfad an den Steueranschluss (10) des Halbleiterschalters (5) ausgebildet ist,
**dadurch gekennzeichnet, dass** die Umschalteinrichtung (28) derart ausgebildet ist, dass sie in eine dritte Funktionsstellung, insbesondere in eine Neutralstellung, schaltbar ist, in der kein Steuerstrom von einem Spannungs-Stromwandler (31; 81, 82) an den Steueranschluss (10) des Halbleiterschalters (5) bereitgestellt wird.

2. Steuereinrichtung nach Anspruch 1, **dadurch gekennzeichnet, dass** die Kopplungseinrichtung als Stromspiegel (23, 33) ausgebildet ist.

3. Steuereinrichtung nach Anspruch 1, **dadurch gekennzeichnet, dass** die Kopplungseinrichtung als Pegelschieber (84, 85), insbesondere als Transistor, ausgebildet ist.

4. Steuereinrichtung nach Anspruch 1, 2 oder 3, **dadurch gekennzeichnet, dass** der Spannungs-Stromwandler (31; 81, 82) wenigstens einen Wirkwiderstand umfasst, der insbesondere ausschließlich als ohmscher Widerstand ausgebildet ist.

5. Steuereinrichtung nach Anspruch 4, **dadurch gekennzeichnet, dass** der Spannungs-Stromwandler (31; 81, 82) als Reihenschaltung von mehreren, insbesondere elektrisch gleichwertigen, Wirkwiderständen ausgebildet ist, die zur Reduzierung von Induktionseffekten mäanderförmig angeordnet sind.

6. Steuereinrichtung nach einem der vorhergehenden Ansprüche, **dadurch gekennzeichnet, dass** der Umschalteinrichtung (28) eine Ansteuereinrichtung (25) zugeordnet ist, die anhand einer vorgebbaren Zeitdauer oder anhand einer Detektion einer minimalen oder maximalen elektrischen Spannung zwischen dem Eingangsanschluss (7) und dem Ausgangsanschluss (8) des Halbleiterschalters (5) zur Umschaltung der Umschalteinrichtung (28) in die dritte Funktionsstellung ausgebildet ist.

7. Verfahren zum Steuern einer nach einem der vorhergehenden Ansprüche ausgebildeten Steuereinrichtung wobei bei einer Änderung einer Spannung über dem Freilaufmittel (21) eine Änderung eines Stromflusses in einem Spannungs-Stromwandler (31; 81, 82), der der Spannung über dem Freilaufmittel (21) parallelgeschaltet ist, als proportionale Steuerstromänderung an einen Steueranschluss (10) des Halbleiterschalters (5) bereitgestellt wird und wobei ein Einschaltvorgang und/oder ein Ausschaltvorgang für den Halbleiterschalter (5) anhand eines von außen zugeführten Steuersignals, das an die Umschalteinrichtung (28) bereitgestellt wird, erfolgt und wobei eine Umschaltung der Umschalteinrichtung (28) aus der ersten oder zweiten Funktionsstellung in die dritte Funktionsstellung nach Ablauf einer vorgebbaren Zeitdauer nach Eintreffen des Steuersignals oder bei Detektion einer vorgebbaren minimalen oder maximalen elektrischen Spannung zwischen dem Eingangsanschluss (7) und dem Ausgangsanschluss (8) und/oder zwischen dem Eingangsanschluss (7) und dem Steueranschluss (10) des Halbleiterschalters (5) vorgenommen wird.

## Claims

1. Control device for influencing an energy flow in a load current circuit (2; 42) between an electric voltage source (3) and an electric load (4; 44), comprising a semiconductor switch (5), which comprises a conductive section (9) which is formed between an input terminal (7) and an output terminal (8) and which can be looped into the load current circuit (2; 42) and the electric resistance of which can be adjusted by means of an electric potential which can be applied to a control terminal (10) associated with the semiconductor switch (5), and further comprising a control circuit (6; 46), which is coupled to the control terminal (10) and which includes suppressor means (21), in particular a suppressor diode, connected in parallel with the load (4; 44), wherein the control circuit (6; 46) is designed for providing a control current to the control terminal (10), which control current is proportional to a suppressor voltage across the suppressor means (21)and wherein the control circuit (6; 46) comprises a voltage/current transformer (31; 81, 82) and a coupling device (23, 33; 84, 85) electrically connected to the voltage/current transformer (31; 81, 82), the coupling device (23, 33; 84, 85) being designed to provide an electric current flowing through the voltage/current transformer (31; 81, 82) in a proportional manner as a control current at the control terminal (10) of the semi-conductor switch (5), wherein the control circuit (6) comprises a first coupling device (33) and a second coupling device (23), each of which is connected to the control terminal (10) of the semiconductor switch (5) and can optionally be connected in series with the voltage/current transformer (31) by means of a switch-over device (28), wherein the control circuit (46) comprises a first control current path with a series circuit made up from a first voltage/current transformer (81) and a first coupling device (84) and a second control current path with a series circuit made up from a second voltage/current transformer (82) and a second coupling device (85), as well as a switch-over device (28), which is designed to provide the control terminal (10) of the semiconductor switch (5) with a control current via the first control current path in a first functional position and to provide a control current via the second current path in a second functional position, **characterised in that** the switch-over device (28) is designed such that it can be switched into a third functional position, in particular a neutral position, in which no control current is provided to the control terminal (10) of the semiconductor switch (5) by any of the voltage/current transformers (31; 81, 82).

2. Control device according to claim 1, **characterised in that** the coupling device is designed as a current mirror (23, 33).

3. Control device according to claim 1, **characterised in that** the coupling device is designed as a level shifter (84, 85), in particular as a transistor.

4. Control device according to claim 1, 2 or 3, **characterised in that** the voltage/current transformer (31; 81, 82) comprises at least one active resistance which is in particular exclusively designed as an ohmic resistance.

5. Control device according to claim 4, **characterised in that** the voltage/current transformer (31; 81, 82) is designed as a series circuit of several, in particular electrically equivalent, active resistances, which are arranged in a meander form to reduce induction effects.

6. Control device according to one of the preceding claims, **characterised in that** the switch-over device (28) is assigned an activation device (25), which is designed to switch the switch-over device (28) into the third functional position after a presettable period of time or in response to the detection of a minimum or maximum electric voltage between the input terminal (7) and the output terminal (8) of the semiconductor switch (5).

7. Method for controlling a control device which is designed according to any of the preceding claims, wherein if a voltage across the suppressor means (21) changes, a change of a current flow in a voltage/current transformer (31; 81, 82) connected in parallel with the voltage across the suppressor means (21) is provided to a control terminal (10) of the semiconductor switch (5) as a proportional control current change, and wherein a switch-on process and/or a switch-off process takes place for the semiconductor switch (5) in response to an externally supplied control signal provided to the switch-over device (28), and in that the switch-over device (28) is switched from the first or second functional position into the third functional position after a pre-settable period of time has elapsed since the arrival of the control signal, or in response to the detection of a minimum or maximum electric voltage between the input terminal (7) and the output terminal (8) and/or between the input terminal (7) and the control terminal (10) of the semiconductor switch (5).

## Revendications

1. Dispositif de commande servant à influencer un flux d'énergie entre une source de tension (3) électrique et un consommateur (4 ; 44) électrique d'un circuit de courant de charge (2 ; 42), comprenant un commutateur à semi-conducteurs (5), qui comprend une section conductrice (9) réalisée entre une borne d'entrée (7) et une borne de sortie (8), pouvant être mise en boucle dans le circuit de courant de charge (2 ; 42), dont la résistance électrique peut être réglée au moyen d'un potentiel électrique, qui peut être appliqué au niveau d'une borne de commande (10) associée au commutateur à semi-conducteurs (5), et comprenant un système combinateur de commande (6 ; 46), qui est couplé à la borne de commande (10) et qui comprend un moyen de roue libre (21) monté en parallèle par rapport au consommateur (4 ; 44), en particulier une diode de roue libre, sachant que le système combinateur de commande (6 ; 46) est réalisé en vue de fournir un courant de commande à la borne de commande (10), lequel courant de commande est proportionnel à une tension de roue libre par l'intermédiaire du moyen de roue libre (21) et sachant que le système combinateur de commande (6 ; 46) comprend un convertisseur de tension-courant (31 ; 81, 82) et un dispositif de couplage (23, 33 ; 84 ; 85) raccordé électriquement au convertisseur de tension-courant (31 ; 81, 82), sachant que l'unité de couplage (23, 33 ; 84, 85) est mise au point pour fournir un courant électrique traversant le convertisseur de tension-courant (31 ; 81, 82) de manière proportionnelle en tant que courant de commande à la borne de commande (10) du commutateur à semi-conducteurs (5),
- sachant que le système combinateur de commande (6) comprend un premier dispositif de couplage (33) et un deuxième dispositif de couplage (23), qui sont raccordés respectivement à la borne de commande (10) du commutateur à semi-conducteurs (5) et qui peuvent être montés au choix en série avec le convertisseur de tension-courant (31) au moyen d'un dispositif de commutation (28), ou
- sachant que le système combinateur de commande (46) comprend un premier trajet de courant de commande présentant un montage en série composé d'un premier convertisseur de tension-courant (81) et d'un premier dispositif de couplage (84) et un deuxième trajet de courant de commande présentant un montage en série composé d'un deuxième convertisseur de tension-courant (82) et d'un deuxième dispositif de couplage (85) ainsi qu'un dispositif de commutation (28), qui est réalisé afin de fournir un courant de commande par l'intermédiaire du premier trajet de courant de commande dans une première position fonctionnelle et afin de fournir un courant de commande par l'intermédiaire du deuxième trajet de courant de commande dans une deuxième position fonctionnelle à la borne de commande (10) du commutateur à semi-conducteurs (5),
**caractérisé en ce que** le dispositif de commutation (28) est réalisé de telle manière qu'il peut être commuté dans une troisième position fonctionnelle, en particulier dans une position neutre, dans laquelle aucun courant de commande n'est fourni par un convertisseur de tension-courant (31 ; 81, 82) à la borne de commande (10) du commutateur à semi-conducteurs (5).

2. Dispositif de commande selon la revendication 1, **caractérisé en ce que** le dispositif de couplage est réalisé sous la forme d'un miroir de courant (23, 33).

3. Dispositif de commande selon la revendication 1, **caractérisé en ce que** le dispositif de couplage est réalisé sous la forme d'un dispositif de décalage de niveaux (84, 85), en particulier sous la forme d'un transistor.

4. Dispositif de commande selon la revendication 1, 2 ou 3, **caractérisé en ce que** le convertisseur de tension-courant (31 ; 81, 82) comprend au moins une résistance active, qui est réalisée en particulier exclusivement sous la forme d'une résistance ohmique.

5. Dispositif de commande selon la revendication 4, **caractérisé en ce que** le convertisseur de tension-courant (31 ; 81, 82) est réalisé sous la forme d'un montage en série de plusieurs résistances actives, en particulier électriquement équivalentes, qui sont disposées de manière à présenter une forme sinueuse aux fins de la réduction des effets d'induction.

6. Dispositif de commande selon l'une quelconque des revendications précédentes, **caractérisé en ce qu'**un dispositif de pilotage (25) est associé au dispositif de commutation (28), lequel est réalisé aux fins de la commutation du dispositif de commutation (28) dans la troisième position fonctionnelle à l'aide d'une durée pouvant être préalablement définie ou à l'aide d'une détection d'une tension électrique minimale ou maximale entre la borne d'entrée (7) et la borne de sortie (8) du commutateur à semi-conducteurs (5).

7. Procédé servant à commander un dispositif de commande réalisé selon l'une quelconque des revendications précédentes, sachant que, dans le cas d'une variation d'une tension par l'intermédiaire du moyen de roue libre (21), une variation d'un flux de courant est fournie dans un convertisseur de tension-courant (31 ; 81, 82), qui est parallèle à la tension par l'intermédiaire du moyen de roue libre (21), en tant que variation de courant de commande proportionnelle à une borne de commande (10) du commutateur à semi-conducteurs (5) et sachant qu'une opération de mise en service et/ou une opération de mise hors service pour le commutateur à semi-conducteurs (5) ont lieu à l'aide d'un signal de commande amené depuis l'extérieur, lequel est fourni au dispositif de commutation (28), et sachant qu'une commutation du dispositif de commutation (28) depuis la première ou la deuxième position fonctionnelle dans la troisième position fonctionnelle est effectuée à l'issue d'une durée préalablement définie, à réception du signal de commande ou lors de la détection d'une tension électrique minimale ou maximale préalablement définie entre la borne d'entrée (7) et la borne de sortie (8) et/ou entre la borne d'entrée (7) et la borne de commande (10) du commutateur à semi-conducteurs (5).
